# EUROPEAN PATENT APPLICATION

(11) **EP 4 734 153 A1**
(43) Date of publication of application: **29.04.2026**
(21) Application number: 24826147.1
(22) Date of filing: 29.05.2024
(51) Int. Cl.: H01L 21/677, H01L 21/683, H01L 21/687, B25J 15/00, B25J 15/06, B25J 11/00

(54) **WAFER SUPPORT STRUCTURE AND WAFER TRANSFER APPARATUS HAVING SAME**

(30) Priority: 23.06.2023 KR 20230081479; 05.10.2023 KR 20230132385
(71) Applicant: Semics Inc., Gwangju-si, Gyeonggi-do 12800 (KR)
(72) Inventor: MOON, Ho Hyeon, Anyang-si, Gyeonggi-do 13924 (KR); BAE, Seunghoon, Seoul 05594 (KR)
(74) Representative: Piticco, Lorena
(86) International application number: PCT/KR2024/007336
(87) International publication number: WO 2024/262825

(57) **Abstract**

A wafer support structure is provided. A wafer support structure according to an aspect of the present invention is coupled to a wafer transfer apparatus and comprises: a plate-shaped upper body having an upper surface on which a wafer can be placed, the plate-shaped upper body having a pair of upper extension portions provided on one side thereof so as to extend in one direction such that both side portions of the lower surface of the wafer are supported thereby, and the plate-shaped upper body having an upper coupling portion provided on the other side thereof and coupled to the wafer transfer apparatus; and a plate-shaped lower body coupled to the lower side of the upper body, the plate-shaped lower body having a pair of lower extension portions provided on one side thereof and shaped so as to correspond to the upper extension portions of the upper body, and the plate-shaped lower body having a lower coupling portion provided on the other side thereof and coupled to the wafer transfer apparatus. The pair of extension portions of the upper body has multiple first holes formed therein so as to communicate with a vacuum pump such that a negative pressure can be formed between the upper body and the wafer placed on the upper surface. The pair of extension portions of the upper body has multiple first grooves formed on the outer surface thereof so as to communicate with an air pump such that a fluid can be ejected to the outside of the pair of extension portions.

## Description

### TECHNICAL FIELD

The present invention relates to a wafer support structure and a wafer transfer apparatus having the same.

### BACKGROUND ART

As the thickness of a wafer decreases, the occurrence of warpage increases. Therefore, when a wafer has a thickness at a certain level or less, it is difficult to load the wafer onto a chuck by the bottom handling method in which an arm performs transfer from the bottom of the wafer.

In order to solve this problem, methods of transferring wafers using a folding wafer transfer method have been used in the past.

However, when using a folding type wafer transfer, a swing up motion of the wafer transfer is required during a process of loading a wafer, and accordingly, it requires the chuck to move forward or backward. As a result, the wafer loading time increases, and production efficiency decreases.

Accordingly, a method for transferring wafers in a non-contact manner is required to safely transfer wafers while minimizing damage to the wafers.

In the past, a method of moving wafers by vacuum suction was used instead of the folding method, but when the degree of warpage exceeded a certain level, there were many cases in which vacuum suction often failed.

### DISCLOSURE

### TECHNICAL PROBLEM

The present invention has been devised to solve the above problems, and an object of the present invention is to provide a wafer support structure that is capable of stable absorption during wafer transfer.

The problems of the present invention are not limited to the problems mentioned above, and other problems that are not mentioned will be clearly understood by those skilled in the art to which the present invention pertains from the description below.

### TECHNICAL SOLUTION

According to an aspect of the present invention, provided is a wafer support structure that is coupled to a wafer transfer apparatus, including: a plate-shaped upper body having an upper surface on which a wafer is placed, having a pair of upper extension portions provided on one side thereof so as to extend in one direction such that both side portions of a lower side surface of the wafer are supported thereby, and having an upper coupling portion provided on the other side thereof and coupled to the wafer transfer apparatus; and a plate-shaped lower body coupled to a lower side of the upper body, having a pair of lower extension portions provided on one side thereof and shaped so as to correspond to upper extension portions of the upper body, and having a lower coupling portion provided on the other side thereof and coupled to the wafer transfer apparatus, wherein the pair of upper extension portions of the upper body has a plurality of first holes formed therein so as to communicate with a vacuum pump such that a negative pressure is formed between the wafer placed on the upper surface and the upper body, and wherein a plurality of first grooves are formed on a lower part of an outer side surface of the pair of upper extension portions or an upper part of an outer side surface of the pair of lower extension portions so as to communicate with an air pump such that a fluid is sprayed to an outer side of the pair of extension portions.

In this case, the upper body may include an upper coupling portion that interconnects one end of the pair of upper extension portions, the lower body may include a lower coupling portion that interconnects one end of the pair of lower extension portions, and the upper coupling portion may be formed to support a perimeter of a lower side surface of the wafer in a state where the wafer is placed on an upper surface.

In this case, the upper coupling portion and lower coupling portion may include a side surface having an arc shape directed toward a center of the wafer placed on the upper surface.

In this case, the plurality of first grooves may be formed in a groove shape in which a part of an outer side surface and a part of a lower surface of the pair of upper extension portions are formed to be simultaneously recessed.

In this case, a first flow path having a shape of an elongated groove may be formed on a lower surface of the upper body to extend so as to communicate the plurality of first grooves and the air pump.

In this case, the plurality of first holes may be disposed to be closer to a center of the wafer than the first flow path.

In this case, a third flow path having a shape of an extended groove may be formed on a lower surface of the upper coupling portion to extend so as to communicate the first flow path and the air pump.

In this case, a second flow path may be formed on the lower extension portion of the lower body to communicate the plurality of first holes and the vacuum pump.

In this case, a fourth flow path may be formed inside the lower coupling portion to communicate the second flow path and the vacuum pump.

In this case, the second flow path may be formed as a hole shape penetrating the lower extension portion of the lower body in a vertical direction, and the wafer support structure may further include a rigid member configured to cover a lower surface of the second flow path.

In this case, the pair of upper extension portions and the pair of lower extension portions may be arranged symmetrically and parallel to each other with respect to a center of a wafer placed on the upper surface.

In this case, the pair of lower extension portions may be each formed with a greater width than the pair of upper extension portions.

In this case, the pair of lower extension portions may be formed to protrude outward a predetermined distance compared to the pair of upper extension portions.

According to another aspect of the present invention, provided is a wafer transfer apparatus, including: the wafer support structure described above for supporting a wafer; a driving module coupled to an upper coupling portion and a lower coupling portion of the wafer support structure, and configured to support the wafer support structure and drive the wafer support structure; and a vacuum pump configured to provide a negative pressure to the wafer through an upper surface of the wafer support structure.

In this case, the wafer transfer apparatus may further include: a pressurization module configured to discharge pressurized air to an outer side of the wafer support structure to form a negative pressure at a lower side portion of the wafer, and an air pump configured to provide a negative pressure to a lower side portion of the wafer through the pressurization module.

### ADVANTAGEOUS EFFECTS

According to the above configuration, the wafer support structure according to one aspect of the present invention can resolve a warpage phenomenon of the wafer and provide a stable adsorption function by forming a low pressure on a lower side surface of a wafer by spraying a fluid to an outer side surface.

It should be understood that the effects of the present invention are not limited to the effects described above, but include all effects that can be inferred from the configurations of the invention described in the detailed description or claims of the present invention.

### DESCRIPTION OF DRAWINGS

FIG. 1 is a drawing showing the configuration of a wafer transfer apparatus according to one embodiment of the present invention.
FIG. 2 is a perspective view of a wafer support structure according to one embodiment of the present invention.
FIG. 3 is an exploded perspective view of a wafer support structure according to one embodiment of the present invention.
FIG. 4 is a drawing showing a view from below of the upper body of a wafer support structure according to one embodiment of the present invention.
FIG. 5 is a drawing showing a top view of the lower body of a wafer support structure according to one embodiment of the present invention.
FIG. 6 is a drawing showing a view from below of the coupling shape of an upper body and a lower body of the wafer support structure according to one embodiment of the present invention.
FIG. 7 is an enlarged view of a part of a wafer support structure in which an upper extension portion and a lower extension portion are located according to one embodiment of the present invention.
FIG. 8A is a cross-sectional view showing a wafer support structure according to one embodiment of the present invention taken along the I-I direction of FIG. 1.
FIG. 8B is a cross-sectional view showing the same part as a part shown in FIG. 8A, regarding a modified example of a wafer support structure according to one embodiment of the present invention.
FIG. 9 is a cross-sectional view showing a wafer support structure according to one embodiment of the present invention, taken along the II-II direction of FIG. 1.
FIG. 10 is a cross-sectional view showing a wafer support structure supporting a wafer according to one embodiment of the present invention.

### MODES OF THE INVENTION

Hereinafter, with reference to the attached drawings, embodiments of the present invention will be described in detail so that those skilled in the art can easily practice the present invention. The present invention may be implemented in various different forms and is not limited to the embodiments described herein. In the drawings, in order to clearly describe the present invention, parts that are not related to the description are omitted, and the same reference numerals are assigned to the same or similar components throughout the specification.

The words and terms used in the present specification and claims should not be construed as limited to their usual or dictionary meanings, but should be interpreted as having meanings and concepts consistent with the technical idea of the present invention, in accordance with the principles by which the inventor can define terms and concepts in order to best describe his or her invention.

In the present specification, it should be understood that terms such as "include" or "have" are intended to describe the presence of a feature, number, step, operation, component, part or combination thereof described in the specification, but do not exclude in advance the possibility of the presence or addition of one or more other features, numbers, steps, operations, components, parts or combinations thereof.

When a component is said to be "in front of," "behind," "above" or "below" another component, unless there are special circumstances, it includes not only being positioned "in front of," "behind," "above," or "below" the other component in direct contact with the same, but also cases where there are other components intervening therebetween. In addition, when a component is said to be "connected" to another component, unless there are special circumstances, it includes cases where they are indirectly connected to each other as well as cases where they are directly connected to each other.

In order to clearly express the features of the configuration in the drawings, the thickness and size are exaggerated, and the thickness and size of the configuration shown in the drawing are not necessarily the same as in reality.

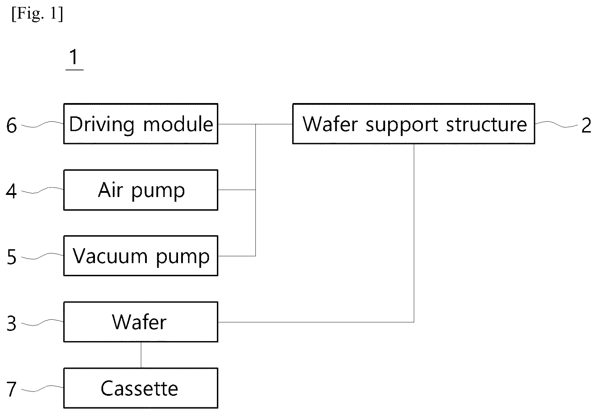

FIG. 1 is a drawing showing the configuration of a wafer transfer apparatus according to one embodiment of the present invention.

A wafer transfer apparatus 1 according to one embodiment of the present invention is a device for transferring a wafer 3 loaded in a cassette 7 to seat on a chuck or sub-chuck, or for returning a seated wafer 3.

A wafer support structure 2 according to one embodiment of the present invention is a component of a wafer transfer apparatus 1 for supporting a wafer 3 through an upper surface on which the wafer 3 can be placed and for transferring the wafer 3. The wafer support structure 2 may be formed to be coupled to the wafer transfer apparatus 1 to transfer the wafer 3.

The wafer transfer apparatus 1 according to one embodiment of the present invention may be configured by including a wafer support structure 2, an air pump 4 for providing a positive pressure, a vacuum pump 5 for forming a negative pressure or vacuum state, and a driving module 6 for driving the wafer transfer apparatus 1. Since the configuration of a wafer transfer apparatus 1 including an air pump 4, a vacuum pump 5 and a cassette 7 is already a known configuration, the detailed description thereof will be omitted.

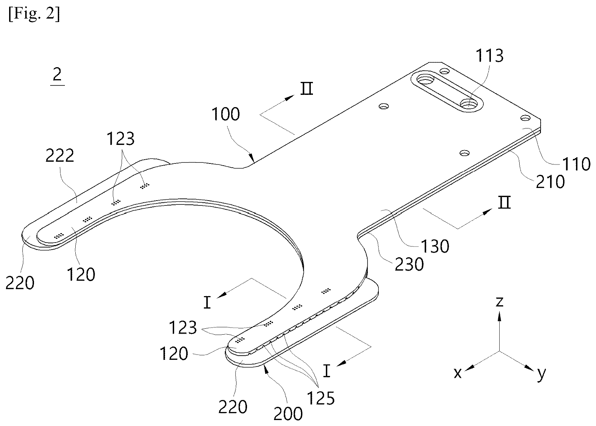

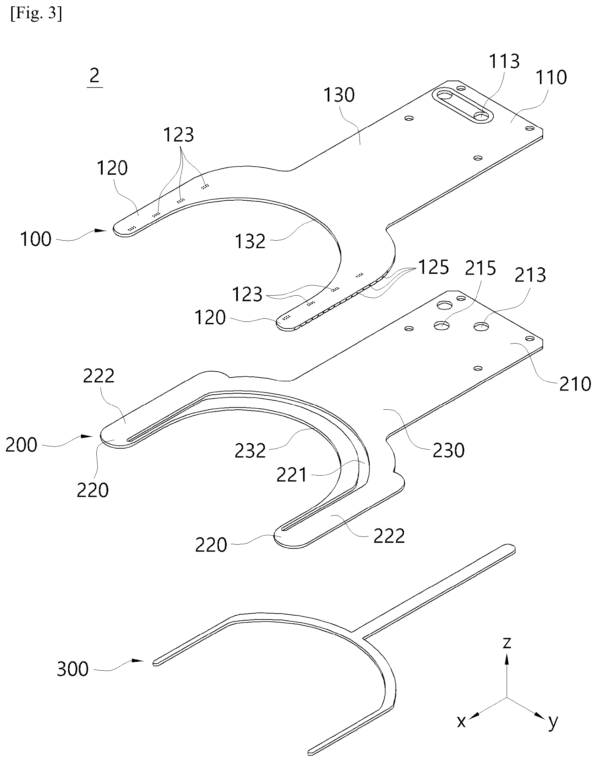

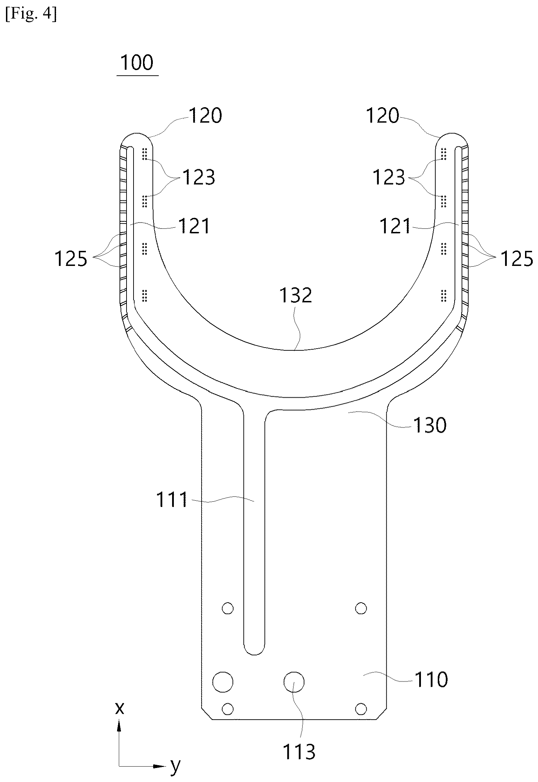

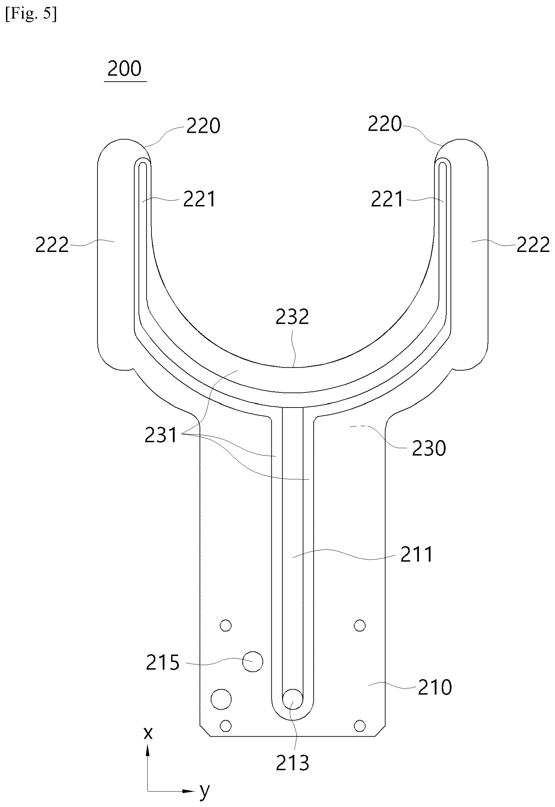

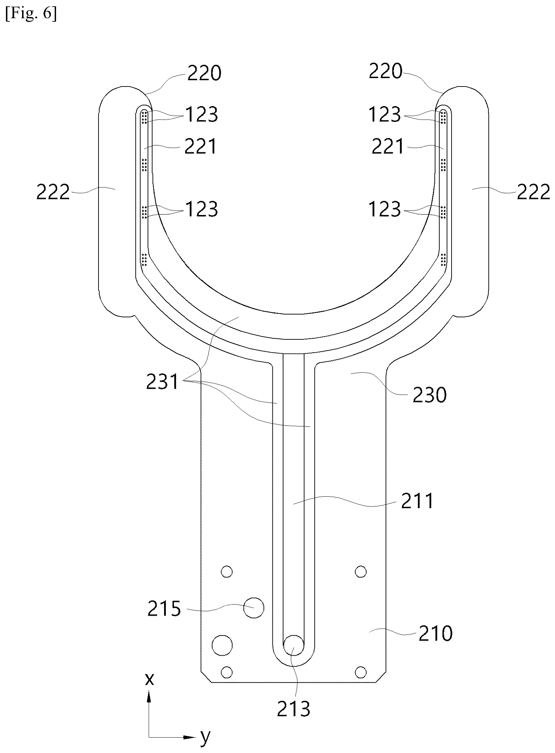

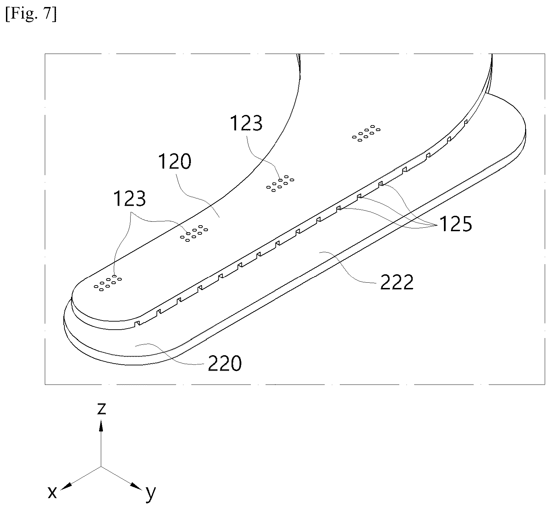

FIG. 2 is a perspective view of a wafer support structure according to one embodiment of the present invention. FIG. 3 is an exploded perspective view of a wafer support structure according to one embodiment of the present invention. FIG. 4 is a drawing showing a view from below of the upper body of a wafer support structure according to one embodiment of the present invention. FIG. 5 is a drawing showing a top view of the lower body of a wafer support structure according to one embodiment of the present invention. FIG. 6 is a drawing showing a view from below of the coupling shape of an upper body and a lower body of the wafer support structure according to one embodiment of the present invention. FIG. 7 is an enlarged view of a part of a wafer support structure in which an upper extension portion and a lower extension portion are located according to one embodiment of the present invention.

As shown in FIGS. 2 and 3, the wafer support structure 2 according to one embodiment of the present invention may be formed by coupling an upper body 100 and a lower body 200 in a vertical direction, that is, along the z-axis direction when viewed in FIGS. 2 and 3.

In this case, a rigid member 300 formed of a material having stronger rigidity than the upper body 100 and the lower body 200 is coupled to a lower side of the lower body 200, that is, on the negative direction side of the z-axis as viewed in FIG. 3, to support a part of the lower body 200 and reinforce the rigidity of the wafer support structure 2.

The upper body 100 of the wafer support structure 2 according to one embodiment of the present invention is a plate-shaped member including an upper surface on which a wafer 3 is placed, a pair of upper extension portions 120 extending in the positive direction of the x-axis based on a center of the upper surface of the upper body 100 as viewed in FIG. 2, an upper coupling portion 110 for coupling to a wafer transfer apparatus 1, and an upper connection portion 130 for connecting the pair of upper extension portions 120 and the upper coupling portion 110.

A pair of upper extension portions 120 may be formed to protrude in parallel in the positive direction of the x-axis from the center of the upper body 100 so as to support both side portions of the lower side surface of the wafer 3, and a pair of upper extension portions 120 may be arranged to be spaced apart from each other in the y-axis direction and symmetrically arranged with the center of the wafer in between.

Referring to FIGS. 2 to 4, the upper extension portion 120 may have a plurality of first holes 123 that are formed to be spaced apart from each other along the extension direction, that is, the positive direction of the x-axis. The first holes 123 may be arranged along the upper extension portion 120 in a plurality of rows as shown, but are not limited thereto and may also be arranged in a single row.

A plurality of first holes 123 may be formed to penetrate the upper body 100 in a vertical direction, that is, along the positive direction of the z-axis.

In this case, the plurality of first holes 123 penetrating the upper body 100 in the vertical direction may communicate with a vacuum pump through a second flow path 221 and a fourth flow path 211 of the lower body 200, when the upper body 100 and the lower body 200 are coupled.

One or more first grooves 125 may be formed on the outer side surface of each of the pair of upper extension portions 120 of the upper body 100 of the wafer support structure 2 according to one embodiment of the present invention.

The first groove 125 may be formed as a groove in which a part of the outer side surface of each of the pair of upper extension portions 120 is recessed inward.

In addition, as shown in FIG. 4, the first groove 125 may be formed in a shape in which a part of the bottom surface of the pair of upper extension portions 120 is recessed such that one end portion faces the outer side surface and one side portion is exposed to the bottom surface.

In this case, one or more first grooves 125 may be formed in plurality to be spaced apart from each other along the outer side surface of the upper extension portion 120.

A first flow path 121 formed as a groove dug to a predetermined depth may be provided on the bottom surface of the pair of upper extension portions 120 of the upper body 100. The first flow path 121 may be formed as one flow path connected from the x-axis direction end side of the upper extensions 120 of the upper body 100 to the lower surface of the upper connecting portion 130.

The first flow path 121 may be formed to communicate with the other end of the first groove 125 formed in the upper extension portion 120 such that the first groove 125 can be communicated with an air pump 4 that provides a positive pressure.

In this case, the first flow path 121 may be disposed within the upper extension portion 120 so as to be located further outward from the center of the wafer 3 than the first hole 123. Accordingly, the first groove 125 and the first flow path 121 may be formed within the wafer support structure 2 so as not to meet the first hole 123.

Referring to FIGS. 2 to 4, an upper connecting portion 130 may be formed at the center of the upper body 100 in the x-y plane, that is, at the center of the upper body 100.

The upper connecting portion 130 may be connected such that the pair of upper extension portions 120 protrude in the positive direction of the x-axis, and the upper coupling portion 110 may be connected such that it protrudes in the negative direction of the x-axis.

The upper connecting portion 130 may be formed to support the lower periphery of the wafer 3, and may be formed to include an arc-shaped side surface 132 facing the center of the wafer 3 placed on the upper extension portion 120.

In this case, a third flow path 111 that communicates with the first flow path 121 and extends toward a lower side surface of the upper coupling portion 110 may be formed on one side of the first flow path 121 formed on the lower surface of the upper connecting portion 130.

The third flow path 111, like the first flow path 121, may be provided as a groove formed at a predetermined depth on the lower surface of the upper body 100.

The third flow path 111 may be connected to an air pump 4 for providing a positive pressure through the lower surface of the upper coupling portion 110. Accordingly, the first groove 125 may communicate with a pressurization module through the first flow path 121 and the third flow path 111.

Such a pressurization module may include an air pump 4, but is not necessarily limited to, and may be changed to a configuration such as a separate pump or compressor that is capable of providing a positive pressure.

The lower body 200 is a component of the wafer support structure 2 according to the present invention that is coupled to a lower side of the upper body 100.

The lower body 200 of the wafer support structure 2 according to one embodiment of the present invention may be formed of a plate-shaped member including an upper surface coupled with the upper body 100, a pair of lower extension portions 220 extending in the positive direction of the x-axis based on the center of the upper surface of the lower body 200 as viewed in FIG. 3, a lower coupling portion 210 for coupling to a wafer transfer apparatus 1, and a lower connecting portion 230 for connecting the pair of lower extension portions 220 and the lower coupling portion 210.

The pair of lower extension portions 220 may be formed to protrude parallel to the positive x-axis from the center of the lower body 200 in a shape corresponding to the upper extension portion 120 such that they can be coupled to a lower side of the upper extension portion 120 of the upper body 100.

In this case, the pair of lower extension portions 220 may be spaced apart from each other in the y-axis direction to be symmetrical with the center of the wafer in between.

In addition, each of the pair of lower extension portions 220 may be formed to have a larger width in the left-right direction, that is, in the y-axis direction as viewed in FIG. 3, than the upper extension portion 120 of the upper body 100.

In this case, the inner side surface of the pair of lower extension portions 220 may be positioned so as to correspond to the inner side surface of each of the pair of upper extension portions 120 and may be coupled to a lower side surface of the upper extension portion 120 along the vertical direction, and at the same time, the outer side surface may be disposed so as to extend further in the left-right direction than the outer side surface of each of the pair of upper extension portions 120.

Accordingly, as shown in FIG. 7, a guide protrusion 222 is formed on the upper surface side portion of the lower extension portion 220 such that when a fluid is sprayed from the first groove 125 provided in the upper extension portion 120, the fluid can exit the first groove 125 and be sprayed along the guide protrusion 222 of the lower extension portion 220.

Referring to FIGS. 2, 3 and 5, a second flow path 221 may be formed in the lower extension portion 220 that penetrates the lower extension portion 220 in the vertical direction along the extension direction, that is, the positive direction of the x-axis.

As shown in FIG. 6, the second flow path 221 may be formed to be positioned below the first hole 123 when the upper body 100 and the lower body 200 are coupled. As a result, the first hole 123 may communicate with the vacuum pump 5 through the second flow path 221.

A lower connecting portion 230 may be formed at the center of the lower body 200, that is, at the center of the lower body 200 in the x-y plane of the lower body.

A pair of lower extension portions 220 may be connected to the lower connecting portion 230 so as to protrude in the positive direction of the x-axis, and a lower coupling portion 210 may be connected so as to protrude in the negative direction of the x-axis.

The lower connecting portion 230 may be formed to include an arc-shaped side surface directed toward the center of the wafer placed on the upper extension portion 120 along the shape of the upper connecting portion 130.

In this case, the second flow path 221 formed by vertically penetrating the lower extension portion 220 may be formed to vertically penetrate and continue to the lower connecting portion 230, and a fourth flow path 211 may be formed on one side of the second flow path 221 formed in the lower connecting portion 230 and extending toward the lower coupling portion 210 in communication with the second flow path 221.

Unlike the second flow path 221, the fourth flow path 211 may be provided as a groove formed at a predetermined depth on a lower surface of the lower coupling portion 210.

The opening of the fourth flow path 211 formed on the lower surface of the lower coupling portion 210 may be covered by a rigid member 300 coupled to the lower surface of the lower body 200.

In order to stably couple the rigid member 300 to the lower surface of the lower body 200, a rigid member coupling groove 231 may be provided on the lower surface of the lower body 200 in which the peripheral parts of the second flow path 221 and the fourth flow path 211 are formed to be recessed to a predetermined depth toward the upper surface of the lower body 200.

The rigid member coupling groove 231 may be formed as a groove having a shape corresponding to the shape of the rigid member 300 for stable coupling.

However, it is not necessarily limited thereto, and it is also possible to form the fourth flow path 211 in the shape of a tunnel formed inside the lower coupling portion 210 without having a rigid member 300 and without a rigid member coupling groove 231.

The fourth flow path 211 may be connected to a vacuum pump 5 for providing a negative pressure or a vacuum pressure through the fourth hole 213 formed by penetrating the lower coupling portion 210 in a vertical direction. Accordingly, the first hole 123 may communicate with the vacuum pump 5 through the second flow path 221 and the fourth flow path 211. The configuration of the vacuum pump 5 may also be changed to another type of pump that provides a negative pressure or a separate member that has a similar function.

Referring to FIG. 4, a second hole 113 may be formed at a position corresponding to the fourth hole 213 on the upper coupling portion 110 of the upper body 100, and when the upper body 100 and the lower body 200 are coupled, the fourth hole 213 and the second hole 113 may be connected to communicate with the vacuum pump 5 and the first hole 123.

Referring to FIGS. 3 and 5, a third hole 215 may be formed in the lower coupling portion 210 at a position that can communicate with the third flow path 111 of the upper coupling portion 110.

Accordingly, the first groove 125 may communicate with the air pump 4 via the first flow path 121 and the third flow path 111 through the third hole 215. The air pump 4 is also not necessarily limited thereto, and may be changed to another configuration capable of performing a similar function.

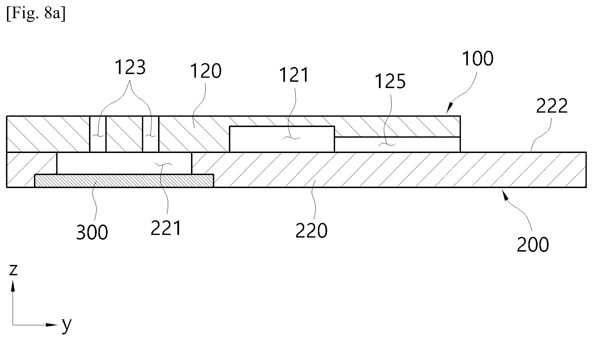

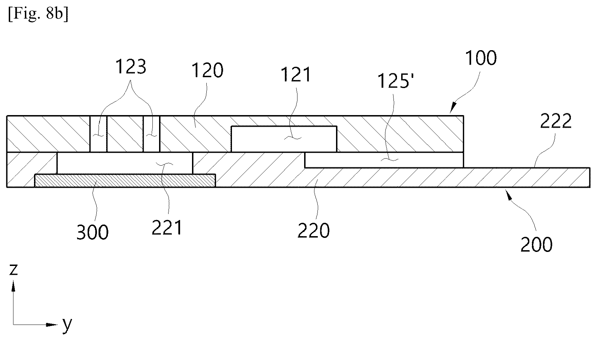

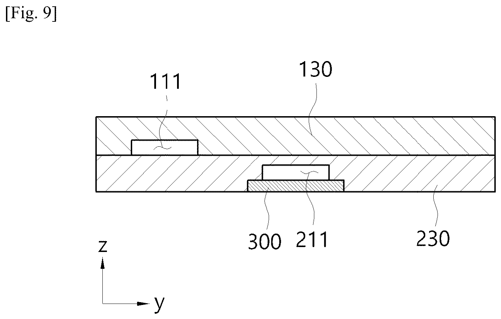

FIG. 8A is a cross-sectional view showing a wafer support structure according to an embodiment of the present invention taken along the line I-I of FIG. 1. FIG. 8B is a cross-sectional view showing the same part as that shown in FIG. 8A, with respect to a modified example of the wafer support structure according to an embodiment of the present invention. FIG. 9 is a cross-sectional view showing a wafer support structure according to an embodiment of the present invention taken along the line II-II of FIG. 1.

Referring to FIG. 8A, when the upper body 100 and the lower body 200 are coupled in the vertical direction, the second flow path 221 is formed on a lower side of the first hole 123 penetrating the upper extension portion 120 and communicates with the first hole 123.

In this case, since the second flow path 221 communicates with the vacuum pump 5, the inside of the second flow path 221 may be in a vacuum state, and thus, the second flow path 221 receives an upper pressure equal to the atmospheric pressure.

In order to correspond thereto, a rigid member 300 formed of a rigid material may be coupled on a bottom surface of the second flow path 221.

In addition, a first groove 125 may be provided on an outer side of the first hole 123 and the second flow path 221, that is, on the positive direction side of the y-axis as seen in FIG. 8A, to be formed in the width direction of the upper extension portion 120, with one end formed on the outer side surface of the upper extension portion 120 and one side portion formed on the lower surface of the upper extension portion 120.

However, the location of the first home 125 is not necessarily limited thereto, and it may be disposed on the lower extension portion 220 rather than the upper extension portion 120.

Referring to FIG. 8B, in a modified example of the wafer support structure 2 according to the present invention, the first groove 125' may be formed to be recessed in an upper part of the outer side surface of the lower extension portion 220 along the y-axis direction so as to communicate with the first flow path 121.

Accordingly, unlike in FIG. 8A where the z-axis direction height of the guide protrusion 222 of the lower extension portion 220 is formed to be the same as the thickness of the lower extension portion 220, the z-axis direction height of the guide protrusion 222 may be formed to be lower than the thickness of the lower extension portion 220 by the height of the first groove 125'.

In this case, the lower extension portion 220 may be formed with a first height portion having the same height as the guide protrusion portion 222, and a second height portion formed with the same height as the lower coupling portion 210 and the lower connecting portion 230.

In this case, only the part of the lower extension portion 220 that overlaps with the upper extension portion 120 on the x-y plane may be formed as the second height portion, and the remaining part may be formed as the first height portion.

However, it is not limited thereto, and considering the rigidity of the wafer support structure 2 and the smooth flow of a fluid, the part formed as the first height portion and the part formed as the second height portion may be formed in different shapes.

On the outer side of the first hole 123 and the second flow path 221, a first flow path 121 is provided that communicates with the other end of the first grooves 125, 125' and is formed as a groove on the lower surface of the upper extension portion 120.

Since the first flow path 121 may communicate with the air pump 4, a positive pressure may be formed inside the first flow path 121 unlike the second flow path 221. Accordingly, the internal fluid may be sprayed in one end direction from the other end of the first grooves 125, 125', that is, in the positive direction of the y-axis as viewed in FIGS. 8A and 8B.

Referring to FIG. 9, when the upper body 100 and the lower body 200 are coupled in the vertical direction, a fourth flow path 211 may be formed at a predetermined depth from the upper surface inside the lower coupling portion 210.

The fourth flow path 211, like the second flow path 221, may have a lower surface thereof covered by a rigid member.

In addition, a third flow path 111 may be formed at a position that does not overlap with the fourth flow path 211 in the y-axis direction.

Since the fourth flow path 211 communicates with the vacuum pump 5 such that the inside can be in a negative pressure or vacuum state and the third flow path 111 communicates with the air pump 4 such that the inside can be in a positive pressure state, if the fourth flow path 211 and the third flow path 111 are too close, the stability of the internal structure may be adversely affected by a pressure difference between the flow paths.

Therefore, as shown in FIG. 9, the structural stability of the wafer support structure 2 may be ensured by sufficiently spacing out the distance between the flow paths.

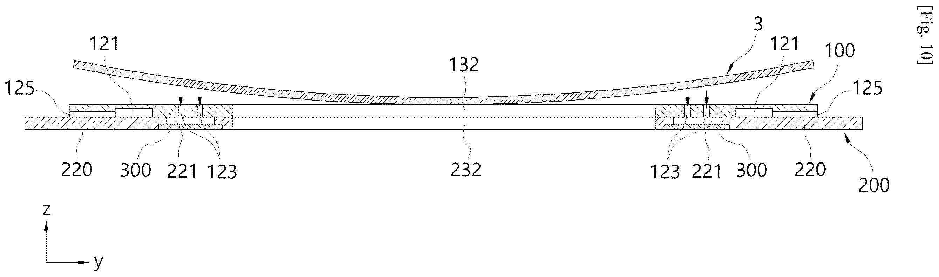

FIG. 10 is a cross-sectional view showing a wafer support structure supporting a wafer according to one embodiment of the present invention.

The cross-section shown in FIG. 10 may be a cross-section cut at the same position as the cross-section shown in FIG. 8A after the wafer 3 is seated on the wafer support structure 2.

When the wafer 3 is simply seated on the wafer support structure 2, the wafer 3 may be warped, and the lower side portion of the wafer 3 may not be stably absorbed into the upper extension portion 120 of the wafer support structure 2, and may be seated with a part separated from the upper surface of the upper extension portion 120 as shown.

In this case, when the air pump 4 is operated to apply a positive pressure to the third flow path 111 and the first flow path 121, the fluid may be sprayed to an outer side of the wafer support structure 2 through the first groove 125.

In this case, the sprayed fluid may be guided in a spraying direction along the upper surface of the guide protrusion 222 of the lower extension portion 220 of the lower body 200 located at one end of the first groove 125.

The fluid with the induced spray direction is sprayed toward the outer side of the wafer support structure 2 along the upper surface of the guide protrusion 222, thereby accelerating the fluid flow on the upper surface of the guide protrusion 222.

As the fluid flow on the upper surface of the guide protrusion 222 becomes faster, a low pressure is formed near the upper surface of the guide protrusion 222 according to Bernoulli's law.

Accordingly, as seen in FIG. 10, the atmospheric pressure is formed on the upper side part of the wafer 3, whereas a low pressure is formed on the lower side part of the wafer 3, and thus, the wafer 3 receives a pressure from the upper side to the lower side, that is, in the negative direction of the z-axis.

At the same time, when the vacuum pump 5 is operated, the inside of the fourth flow path 211, the second flow path 221 and the first hole 123 may be in a negative pressure or vacuum state.

Accordingly, a negative pressure is formed on the upper side of the first hole 123, and pressure may be generated to pull the lower part of the wafer 3 downward.

By the pressure applied to the wafer 3 in this manner, the warpage of the wafer 3 may be eliminated, and the wafer 3 may be stably seated and absorbed on the upper extension portion 120 of the wafer support structure 2.

According to the above configuration, the wafer transfer apparatus 1 and wafer support structure 2 according to one embodiment of the present invention may provide a wafer support structure 2 that is capable of stable adsorption when transferring a wafer 3.

In addition, the wafer transfer apparatus 1 and wafer support structure 2 according to one embodiment of the present invention may eliminate the warping phenomenon of the wafer 3 and provide a stable adsorption function by forming a low pressure on the lower side surface of the wafer 3 by spraying a fluid to the outer side surface.

In addition, the wafer transfer apparatus 1 and the wafer support structure 2 according to one embodiment of the present invention may form a low pressure or vacuum state at the bottom of the wafer 3 to eliminate the warping phenomenon of the wafer 3 and provide a stable adsorption function.

Although one embodiment of the present invention has been described above, the concept of the present invention is not limited to the embodiment presented in the present specification, and those skilled in the art who understand the concept of the present invention will be able to easily propose other embodiments by adding, changing, deleting or supplementing components within the scope of the same concept, but this will also be considered to fall within the concept of the present invention.

## Claims

1. A wafer support structure that is coupled to a wafer transfer apparatus, comprising:
a plate-shaped upper body having an upper surface on which a wafer is placed, having a pair of upper extension portions provided on one side thereof so as to extend in one direction such that both side portions of a lower side surface of the wafer are supported thereby, and having an upper coupling portion provided on the other side thereof and coupled to the wafer transfer apparatus; and
a plate-shaped lower body coupled to a lower side of the upper body, having a pair of lower extension portions provided on one side thereof and shaped so as to correspond to upper extension portions of the upper body, and having a lower coupling portion provided on the other side thereof and coupled to the wafer transfer apparatus,
wherein the pair of upper extension portions of the upper body have a plurality of first holes formed therein so as to communicate with a vacuum pump such that a negative pressure is formed between the wafer placed on the upper surface and the upper body, and
wherein a plurality of first grooves are formed on a lower part of an outer side surface of the pair of upper extension portions or an upper part of an outer side surface of the pair of lower extension portions so as to communicate with an air pump such that a fluid is sprayed to an outer side of the pair of extension portions.

2. The wafer support structure of claim 1, wherein the upper body comprises an upper coupling portion that interconnects one end of the pair of upper extension portions, the lower body comprises a lower coupling portion that interconnects one end of the pair of lower extension portions, and the upper coupling portion is formed to support a perimeter of a lower side surface of the wafer in a state where the wafer is placed on an upper surface.

3. The wafer support structure of claim 2, wherein the upper coupling portion and lower coupling portion comprise a side surface having an arc shape directed toward a center of the wafer placed on the upper surface.

4. The wafer support structure of claim 1, wherein the plurality of first grooves are formed in a groove shape in which a part of an outer side surface and a part of a lower surface of the pair of upper extension portions are formed to be simultaneously recessed.

5. The wafer support structure of claim 1, wherein the plurality of first grooves are formed in a groove shape in which a part of an outer side surface and a part of an upper surface of the pair of lower extension portions are formed to be simultaneously recessed.

6. The wafer support structure of claim 1, wherein a first flow path having a shape of an elongated groove is formed on a lower surface of the upper body to extend so as to communicate the plurality of first grooves and the air pump.

7. The wafer support structure of claim 6, wherein the plurality of first holes are disposed to be closer to a center of the wafer than the first flow path.

8. The wafer support structure of claim 6, wherein a third flow path having a shape of an extended groove is formed on a lower surface of the upper coupling portion to extend so as to communicate the first flow path and the air pump.

9. The wafer support structure of claim 1, wherein a second flow path is formed on the lower extension portion of the lower body to communicate the plurality of first holes and the vacuum pump.

10. The wafer support structure of claim 9, wherein a fourth flow path is formed inside the lower coupling portion to communicate the second flow path and the vacuum pump.

11. The wafer support structure of claim 9, wherein the second flow path is formed as a hole shape penetrating the lower extension portion of the lower body in a vertical direction, and
wherein the wafer support structure further comprises a rigid member configured to cover a lower surface of the second flow path.

12. The wafer support structure of claim 1, wherein the pair of upper extension portions and the pair of lower extension portions are arranged symmetrically and parallel to each other with respect to a center of a wafer placed on the upper surface.

13. The wafer support structure of claim 1, wherein the pair of lower extension portions are each formed with a greater width than the pair of upper extension portions.

14. The wafer support structure of claim 2, wherein the pair of lower extension portions are formed to protrude outward a predetermined distance compared to the pair of upper extension portions.

15. A wafer transfer apparatus, comprising:
the wafer support structure according to any one of claims 1 to 13 for supporting a wafer;
a driving module coupled to an upper coupling portion and a lower coupling portion of the wafer support structure, and configured to support the wafer support structure and drive the wafer support structure; and
a vacuum pump configured to provide a negative pressure to the wafer through an upper surface of the wafer support structure.

16. The wafer transfer apparatus of claim 15, further comprising:
a pressurization module configured to discharge pressurized air to an outer side of the wafer support structure to form a negative pressure at a lower side portion of the wafer, and
an air pump configured to provide a negative pressure to a lower side portion of the wafer through the pressurization module.
